# EUROPEAN PATENT APPLICATION

(11) **EP 4 556 787 A1**
(43) Date of publication of application: **21.05.2025**
(21) Application number: 23210732.6
(22) Date of filing: 17.11.2023
(51) Int. Cl.: F21S 45/47, F21S 45/49, F21S 41/141, F21S 41/19, F21S 43/14, F21S 43/19, H01L 33/64, H05K 1/02

(54) **COOLING ASSEMBLY FOR A LIGHT SOURCE AND VEHICLE LAMP WITH THE ASSEMBLY**

(71) Applicant: Hella Autotechnik Nova, s.r.o., 78985 Mohelnice (CZ)
(72) Inventor: Machycek, David, 783 61 Hlubocky (CZ); Müller, Petr, 789 85 Mohelnice (CZ)
(74) Representative: Behr-Wenning, Gregor

(57) **Abstract**

Cooling assembly for a light source for a vehicle lamp (1) and vehicle lamp with the assembly. The assembly comprises a metal core PCB (2) and at least one cooling fin (3). Each cooling fin (3) can be attached to the PCB (2) by at least one attaching arm (4) which can at least partially surround the PCB (2). The attaching arm(s) (4) can be elastic.

## Description

### Technical field

The present invention relates to a cooling assembly for conducting and dissipating heat from light sources in a vehicle lamp, when the light sources are arranged on a metal core PCB.

### Background of the Invention

In the state of the art, standard basic components of a vehicle lamp are a light source, a heat sink for the light source, several optical elements such as lenses or reflectors, and a casing or cover. These components can form a so-called module, and a vehicle lamp, such as a headlight or a taillight, can then contain several modules for various illumination functions. The heat sink and light source usually are a PCB with LEDs glued to an aluminum plate with heat dissipation fins.

Different lamps have different requirements for shape of heat sink. Two main factors affecting the shape are heat production along the PCB, which changes with different LEDs and different LED arrangements, and space available in the lamp's casing for the heat sink. As a result, it is often impossible to use any sort of universal heat sink which could be used in different types of lamps. Each new lamp design also requires a new heat sink design. This increases costs of designing and producing new types of lamps, e.g., new headlights for a new make of an automobile.

It would therefore be an advantage, to provide a heat sink construction which could be to some extent reused in different types of lamps, wherein this reusing would be cheaper than wholly designing and producing a new shape of heat sink.

### Summary of the Invention

The shortcomings of the solutions known in the prior art are to some extent eliminated by a cooling assembly for a light source for a vehicle lamp, wherein the assembly comprises a printed circuit board (PCB) and at least one cooling fin. Multiple cooling fins are preferable, but a single fin can be sufficient. The printed circuit board comprises a metal core. The assembly further comprises at least one attaching arm for at least partially surrounding the printed circuit board and for attaching each cooling fin to the printed circuit board. Each cooling fin is preferably secured to at least one attaching arm.

The core of a PCB is its main structural component. Commonly, it is made from a composite of glass fiber and a resin, but metal core PCBs are also known in the art. Metal core PCBs can provide several advantages, such as better heat dissipation, increased strength, and easier recyclability. The PCB itself is however not sufficiently efficient heat sink, so additional heat sinks are still required in vehicle lamps even if metal core PCBs are used. The metal core can then carry a layer of insulation which carries conductive traces, surfaces for mounting of components etc.

The back side of the core, i.e., the side not carrying the traces, is preferably without insulation or any other components, so that the cooling fin(s) can be placed in direct contact with the core. Indirect contact between the core and the fin(s) via a piece of metal forming the arm(s) is also possible and would provide sufficient heat transfer. There should however preferably be no insulator between the core and the fin. Each fin preferably has a base, which can be placed in contact with the core such that the contact has a sufficient area for heat transfer, and at least one heat-dissipation branch. Both the base and the branch(es) can be made from a sheet of metal, such as aluminum.

Each cooling fin can have its individual attaching arm or multiple attaching arms. The arm(s) are then preferably fixed to the fin. It is however also possible to have one or more attaching arms common for multiple cooling fins. Providing at least one individual attaching arm for each cooling fin and firmly connecting the arm to the fin is however preferable, since it simplifies mounting/assembly. Each fin can then be positioned and attached to the PCB separately. Each arm preferably at least partially surrounds the PCB from two sides, for example fully from a lateral side and partially from the top. The bottom side of the PCB can then be braced against the fin.

The attaching arms are preferably made from metal to provide sufficient durability and to increase heat transfer. Plastic arms are however also possible for some variants of the assembly. For each cooling fin, the one or more arms preferably enable grabbing the PCB at two opposite edges, such that the PCB is held by the arms at least at the two edges and the resulting connection between the fin and the PCB is stable. Additional means for fixing the fin to the PCB can be provided, such as gluing, welding, soldering, binding by an additional strip of material etc. Using such additional means can help preventing vibrations of the fin, when the vehicle travels, and movement of the fin during long-term use of the vehicle.

When the at least one fin is mounted to the PCB, the respective arm(s) thus surrounds part of the PCB and thus limits movement between the PCB and the fin. It can still be possible to remove the fin without destruction of the arm, as described below. It can also be possible to shift the fin along the PCB in one axis when friction between the PCB and the fin is overcome.

The assembly thus enables the fin(s) to be mounted at various places on the PCB, for example anywhere along its length or width; or at many different predefined positions along its length or width. The final shape of the cooling assembly, which is given by size and shape of the fins and by the arrangement of the fins on the PCB, can thus be adjusted as needed, when the assembly is being assembled. The same PCB with the same fins can thus be used for forming many different heat sink configurations. The cooling fins can for example be placed only along certain part of the PCB, if there is no space for the fins along the rest of the PCB. Spacing between the fins can be chosen according to temperature / heat production of individual LEDs, e.g., there can be more fins at parts of the PCB with more LEDs.

In one advantageous configuration, there is a fin provided under each LED. The arrangement of fins is thus given by the arrangement of LEDs.

The assembly can also comprise multiple different types of fins. E.g., some fins can be longer or wider than others, to adjust the resulting heat sink shape according to the space available in the lamp for placing the heat sink into. Some fins can have more branches, e.g., more parallel sheets of metal, than other fins, to provide higher heat dissipation at certain places, such as under more powerful LEDs.

The main advantage of the presented assembly is thus in its modularity - certain number of components can be used to provide myriads of individually shaped and sized heat sink cooling assemblies. A lamp manufacturer can thus for example have several predetermined types of PCBs (with different shapes and/or sizes, different thicknesses, different positions of mounting surfaces for components etc.) and several types of fins (with different shapes and sizes, differently formed attaching arms etc.) and from this limited set of components, a suitable heat sink for any potential lamp type can be assembled. Improving an existing heat sink is then also simplified, e.g., adding a fin or decreasing distances between fins, if there is overheating, or removing a fin, if it collides with some other lamp component. This improving would require minimal modifications of manufacturing processes and wouldn't necessarily require producing any new components.

The assembly can thus provide users with a novel method for creating a heat sink assembly. In this method, there are certain available components - at least one PCB with metal core and at least one cooling fin. Preferably, there are multiple cooling fins. All the fins can have the same shape, but different shapes and sizes of fins can be available. In the method, fins are individually mounted on the PCB in any positions, as chosen by a skilled person. Preferably, the number and positions of fins are based on expected need for heat dissipation (especially based on types of components (especially LEDs) which are to be used on the PCB and their arrangement on the PCB - this can be e.g., given by a production documentation for given lamp) and based on space, which will be available for the heat sink in the resulting lamp (e.g., given by a shape of the lamp's casing and by arrangement of other components in the lamp). The attaching arms are used for the mounting of the fins - each arms provides a mechanical connection between at least one fin and the PCB.

This method leads to creating of any required heat sink, and is relatively cheap and easy to implement, especially when compared to heat sink production method where the whole heat sink is from one piece of material.

At least one cooling fin in the assembly according to the present invention can be detachably connected to the printed circuit board by the at least one attaching arm. The detachable connection allows for easy modifications in arrangement of the fins.

For at least one cooling fin, at least one corresponding attaching arm (i.e., the arm or one of the arms for attaching this fin to the PCB) can form a snap-on connection for mechanical attachment of the cooling fin to the printed circuit board. Fins can be mounted via the arms without need for any tools. A snap-on connection utilizes elasticity of materials, in this case of the arm(s) or parts thereof, to provide a mechanical connection. For example, two arms can be provided on the fin, and the arms are forced apart during mounting of the fin to the PCB. Elastic force from the arms can then pull the fin towards the PCB.

For at least one cooling fin, at least one corresponding attaching arm can be made from a different, more elastic material than the cooling fin. This enables the fin to be made from a suitable highly conductive material (especially aluminum) while the arms are sufficiently elastic and strong.

For at least one cooling fin, at least one corresponding attaching arm can be made in one piece with the cooling fin and from the same material. This simplifies manufacture of the fins.

For at least one cooling fin, there can be at least two corresponding attaching arms in total, wherein after mounting, the printed circuit board is held between the at least two attaching arms. Preferably, there are two or possibly more arms for each cooling fin. With two arms, the PCB can be caught at two opposite edges. Both the arms can be relatively short, e.g., if they are placed at opposite ends of the width of the fin, and are thus less prone to breaking during assembly or use.

For at least one cooling fin, at least one corresponding attaching arm can be elastically deformable during mounting of the cooling fin onto the printed circuit board and presses on the printed circuit board when the cooling fin is mounted to the printed circuit board. In other words, the arm is bent during mounting and remains tensioned after the mounting. Part of the spring energy stored in the arm thus provides a holding force which pushes the arm into the PCB.

For at least one cooling fin, at least one corresponding attaching arm can be plastically deformable during mounting of the cooling fin onto the printed circuit board. This can be the case e.g., when the arm is from aluminum or other pliable metal, e.g., when it is from one piece of material with the fin.

There are thus several different kinds of attaching arms that can be used in the assembly, e.g., plastically or elastically deformable arms, there can be different number of arms for each cooling fin etc. For one assembly it can be advantageous, if all the fins which are to be mounted on one PCB, have the same arms. I.e., each fin then has the same number and material and shape of arms. Each fin is thus mounted in the same way, which is preferred for easier assembly. Especially, it is advantageous, if all the arms of all the fins, which are included in the assembly and are to be mounted on the PCB, are either mainly elastically deformable during use, or mainly plastically deformable during use.

The printed circuit board can have at least two mutually opposite edges which are both flat, wherein the at least one cooling fin is attachable by the at least one attaching arm to the printed circuit board at any place along the two edges. The edges can be flat on the top side of the PCB, on the bottom side and/or on the lateral sides, depending on where the arms contact the PCB. In other words, the flat edges enable the fin with the arms to be shifted along the PCB once friction is overcome, unless there is some obstacle in the way (e.g., a component soldered on the PCB) or the additional attaching means is provided. The flat edges are easier to manufacture and shifting of the fins provides easier modification of the resulting heat sink. Without any additional attaching means, the fins can however then be prone to vibrations.

Alternatively or additionally, the printed circuit board can have at least two mutually opposite edges, wherein at least one of the two edges comprises multiple notches for receiving a part of an attaching arm, wherein the notches are spaced apart from each other. Preferably, both the opposite edges have the notches. The notches are thus shaped parts of the PCB, formed e.g., by adding and/or removing material, which prevent, at least to some extent, movement of the arms along the PCB. At the notches, the PCB has a smaller cross-section, while around the notches, the cross-section is larger, which prevents the arms surrounding the PCB at the notches from easily shifting towards the larger cross-section.

The width of notches can be larger than the widths of the arms, so that the arms can fit into the notches. It is however also possible to e.g., provide a rib on each arm, and the notches then only need to be wide enough for receiving the rib. In this way, the distances between different adjacent positions of the fin on the PCB can be smaller than the width of the arms. For example, there can be from 1 to 10 notches per cm of the length or width of the PCB.

The core of the printed circuit board and at least one cooling fin, preferably all the cooling fins, can be made from the same metal. Especially if the fins are in direct contact with the core, this improves heat transfer between the components.

The printed circuit board can comprise multiple LEDs, wherein the assembly comprises at least two cooling fins in total, wherein the cooling fins can then be mounted to the printed circuit board with their positions based on positions of the LEDs on the printed circuit board. In other words, the fins are placed such that the LEDs' positions are considered for the fin placement. As stated above, one advantageous arrangement of the fins is when each LED has a fin under it (i.e., aligned with it on the opposite side of the PCB). Other suitable arrangement is achieved by placing at least one fin between each two adjacent LEDs along the PCB's length or width. Other arrangements which reflect the LED arrangement can be apparent to a skilled person.

A suitable arrangement of fins for a certain PCB layout can be found by placing a default number of fins equidistantly on a PCB with LEDs, e.g., placing one fin per each centimeter of the PCB's length, and then turning the LEDs on. After subsequently measuring temperature distribution along the PCB, it is then possible to modify the default fin arrangement. For example, by adding fins where the temperature is too high and/or decreasing distances between fins and/or using fins with more branches etc., or conversely removing fins where the temperatures are low enough to justify that and/or increasing distances between the fins and/or using fins with smaller surface area, etc.

The printed circuit board advantageously has a thickness of at least 1.5 mm, preferably at least 2 mm. Due to the metal core, increased thickness of the PCB improves heat transfer to the fins. More heat can be accumulated into a thicker PCB, which helps prevent overheating of individual LEDs. Even if there are areas of the PCB, where there are some LEDs but no room for fins, the PCB can transfer the heat away efficiently enough.

The PCB itself is however not enough for a sufficient cooling of the components on the PCB, especially the LEDs. At least one cooling fin is therefore needed.

The cooling assembly can comprise at least three cooling fins in total, wherein the cooling fins can be nonuniformly arranged on the printed circuit board. This means that distances between adjacent fins are different. The nonuniformity can be desired e.g., due to nonuniformity of heat production along the PCB, nonuniformity of cooling intensity of a ventilator along the PCB, insufficient space for fins at certain areas etc.

The shortcomings of the solutions known in the prior art are to some extent also eliminated by a vehicle lamp comprising a light source and the cooling assembly according to the invention. The light source is attached to the printed circuit board of the cooling assembly. This lamp provides analogous advantages as described above for the assembly.

### Description of drawings

A summary of the invention is further described by means of exemplary embodiments thereof, which are described with reference to the accompanying drawings, in which:
- Fig 1.: Schematically shows a sideview of an exemplary arrangement of fins on a PCB of a cooling assembly according to the present invention, wherein there are multiple mounting surfaces for LEDs on the PCB, some of which are provided with an LED, and the fins are distributed around the LEDs.
- Fig 2.: Schematically shows another sideview of an arrangement of fins on a PCB, where in comparison to fig. 1, the LEDs are at different positions and consequently, the fins are also at different positions such that they still surround the LEDs.
- Fig 3.: Schematically shows a front view of a PCB with a cooling fin mounted thereon, wherein the cooling fin has two elastic attaching arms fixed to one of its ends, and the attaching arms hold the PCB between them.
- Fig 4.: Schematically shows how the attaching arms from fig.3 can bend elastically when the fin is being mounted to the PCB or removed from the PCB.
- Fig 5.: Schematically shows a top view of a PCB with several LEDs and three cooling fins attached at the bottom, wherein the PCB has two edges with notches and each of the cooling fins has two attaching arms mounted in two opposite notches so that the cooling fins cannot be shifted along the PCB without forcing the attaching arms away from the notches.
- Fig 6.: Schematically shows a sideview of the cooling assembly from fig. 5.
- Fig 7.: Schematically shows a top view of a PCB with several LEDs and three cooling fins attached at the bottom, wherein the PCB has flat edges without notches. Each of the cooling fins has two attaching arms, each arm being hooked by one of the edges.
- Fig 8.: Schematically shows a sideview of the cooling assembly from fig. 7.
- Fig 9.: Schematically shows a front view of an alternative embodiment of the invention, wherein a PCB with a cooling fin is shown and the fin has two differently shaped attaching arms. One of the attaching arms is angular and the PCB can be pushed into the arm during mounting of the cooling fin, while the other attaching arm is curved and can be elastically deformed during the mounting.
- Fig 10.: Schematically shows a front view of another alternative embodiment of the invention, wherein a PCB with a cooling fin is shown and the fin has a single elastic attaching arm which extends around three sides of the PCB and contacts all three of the sides.
- Fig 11.: Schematically shows how an attaching arm from a plastically deformable material can be secured to a PCB by pressing the arm into a notch by a pressing tool, wherein a state before the pressing is shown, and movement of the tool is indicated.
- Fig 12.: Shows the situation from fig. 11 after the pressing, wherein the cross-section of the attaching arm is deformed such that it is fixed in the notch and vibrations between the PCB and the fin or the arm are prevented.
- Fig 13.: Shows a simplified drawing of a vehicle lamp, such as a high beam module for headlight. Two optical elements, lamp casing and the assembly according to the invention are included in this lamp. The casing is shaped such that a symmetrical heat sink along the whole PCB could not be used, so a nonuniform arrangement of fins is advantageously used.
- Fig 14.: Shows a modification of the embodiment from fig. 3, where each attaching arm is further secured to the PCB by additional attachment means in the form of a metal binding strip.
- Fig 15.: Shows a modification of the embodiment from fig. 10, where a binding strip is used similarly to fig. 14.

### Exemplary Embodiments of the Invention

The invention will be further described by means of exemplary embodiments with reference to the respective drawings.

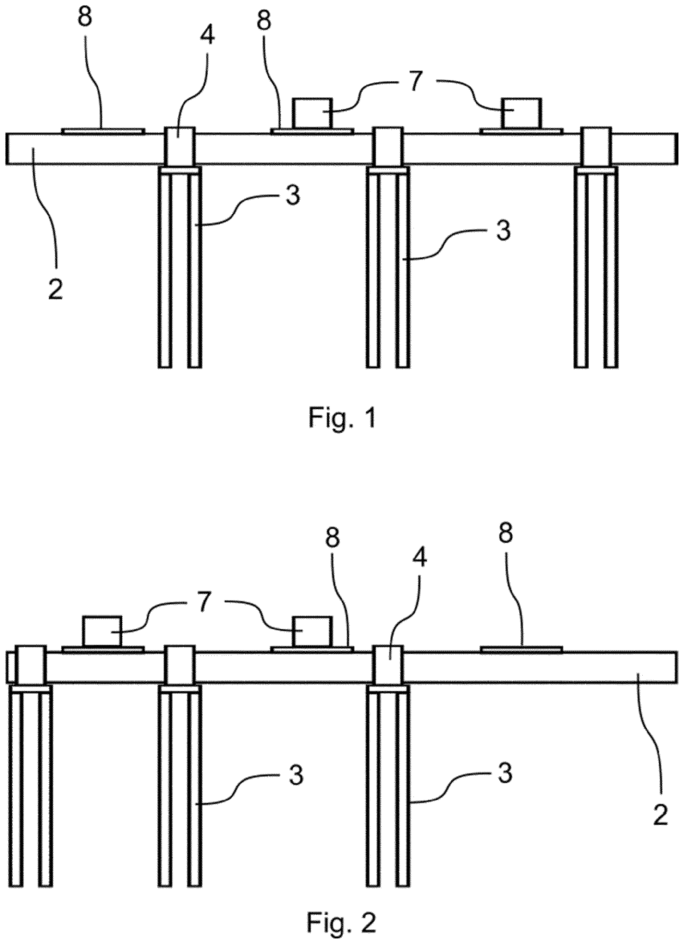

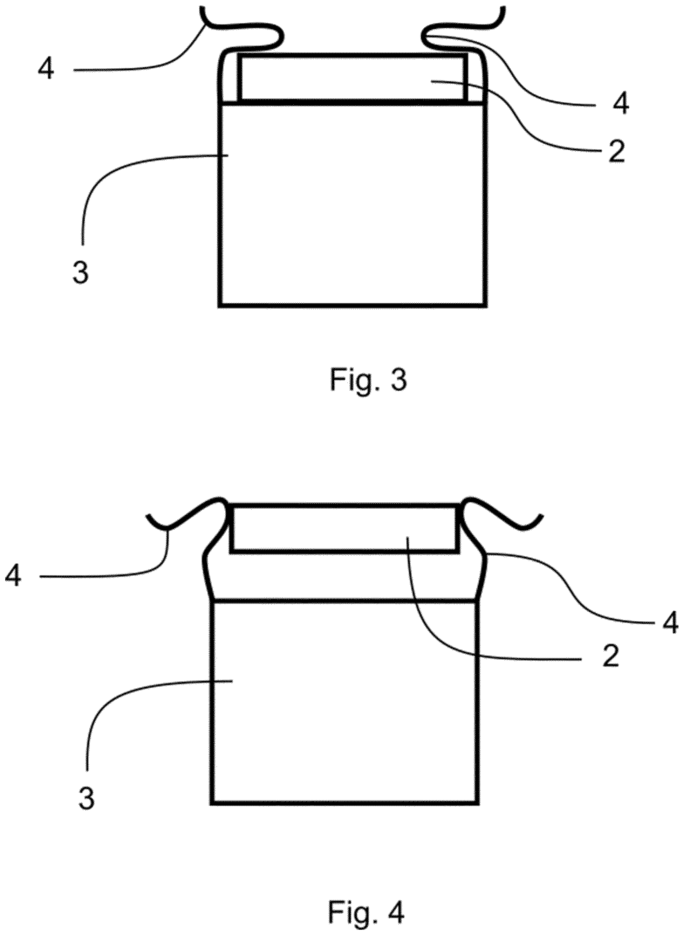

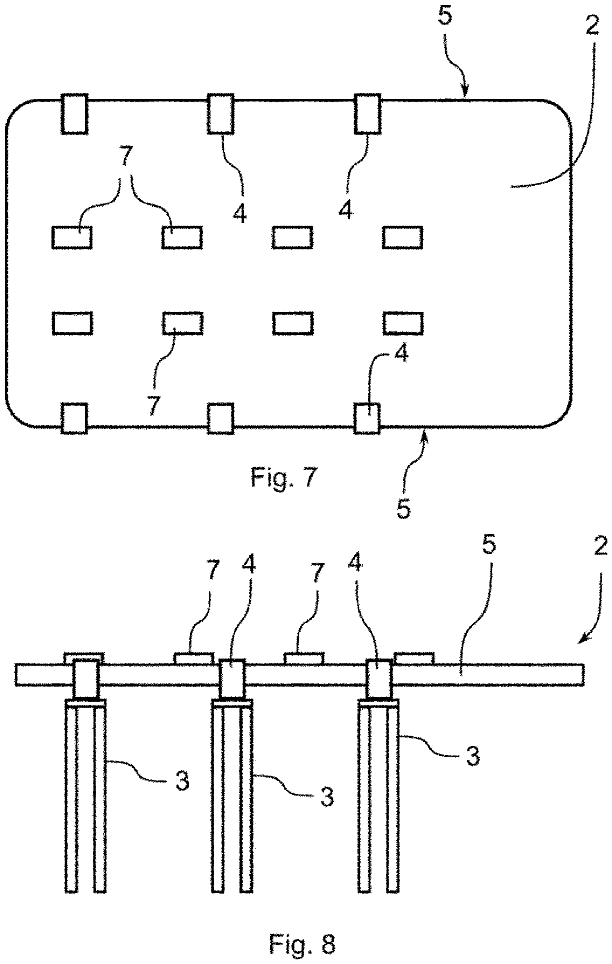

A first exemplary embodiment of the invention is shown in figs. 1, 3, and 4. Top view of this embodiment is analogous to the view of figs. 7 and 8, except that the number of fins and LEDs 7 is different. Cooling assembly for a vehicle headlight according to this embodiment comprises a PCB 2 with aluminum core. The assembly further comprises three cooling fins 3, each with two attaching arms 4 for holding the fin at the PCB 2, as can be seen in fig. 3.

The PCB 2 has an insulation layer on top and conductive traces with mounting surfaces 8 for components on the insulation layer. There are two LEDs 7 soldered to the PCB 2. Thickness of the PCB 2 is 2 mm, which enables the aluminum core to function as a heat sink. The cooling fins 3 then improve heat dissipation of the PCB 2 core. As can be seen in fig. 1, the PCB 2 has more mounting surfaces 8 for LEDs 7 than LEDs 7. The same PCB 2 can thus be used for different illumination functions or different headlights by putting LEDs 7 at different appropriate places. The modularity of the cooling fins 3, which will be described in more detail below, then further increases this versatility of the PCB 2, since the cooling fins 3 can be placed anywhere along the PCB 2, e.g., according to heat production of different components on the PCB 2, according to available space for the fins in a headlight casing 12, according to ventilator placement, etc.

As can be seen in figs. 7 and 8, the PCB 2 has a rectangular shape with rounded corners. The cooling fins 3 extend along the width of the PCB 2 and the arms are thus placed on the longer edges 5 of the PCB 2. The edges 5 in this embodiment are flat, i.e., the PCB 2 has a constant cross-section along most of its length.

The cooling fins 3 are detachably attached to the PCB 2 by means of the attaching arms 4. Each cooling fin 3 has two curved arms fixed to one of its ends. The fin itself is from aluminum in order to provide high heat conductivity and dissipation, while the arms are from a spring steel. A single strip of steel is used to form both attaching arms 4. A middle portion of the strip is riveted to the cooling fin 3. Each arm has a curved protruding portion extending towards the other arm, such that between the protruding portions and the middle portion, there is an appropriately sized opening for the PCB 2. The middle portion of the strip thus serves as a base for the fin, which facilitates contact between the fin and the PCB 2 core.

Fig. 4 shows how the attaching arms 4 can be elastically bent when the fin is mounted to / dismounted from the PCB 2. When the PCB 2 is held between the arms, both the arms remain to some extent tensioned so that they push onto the PCB 2 and hold the cooling fin 3 steady. There is no additional attaching means, such as welding or gluing in this embodiment. With sufficient force, the fins can thus be shifted along the edges 5 of the PCB 2. The attaching arms 4 in this embodiment can thus simply be snapped-on the PCB 2 so they are fairly easy to mount and dismount. No tools are necessary for this snap-on mounting, thought it is possible to use tools or robotic arms etc. for the mounting.

In the first embodiment, each cooling fin 3 comprises two parallel branches, i.e., it comprises two sheets of aluminum with an air gap in between. The branches are connected by connecting portion which also serves for attaching the attaching arms 4. Both branches in this embodiment are made by bending a single sheet of aluminum 90° at two places, such that the connection portion is the part of the sheet between the bends.

A second exemplary embodiment, shown in figs. 2, 3 and 4, is the same as the first embodiment, except that one of the LEDs 7 is moved to another mounting surface 8 for LED 7. The rightmost cooling fin 3 from fig. 1 was thus moved to the left side of the PCB 2 in order to keep both the LEDs 7 surrounded by cooling fins 3 from both sides. This embodiment thus demonstrates, when considered together with the first embodiment, how the independent attachment of individual fins to the PCB 2 to provide the necessary cooling can be advantageous. There is no need to provide a whole new heat sink. Only the placement of the cooling fins 3 is different when the LED 7 placement was changed. There is thus only a slight alteration in the manufacturing process of the assembly - one of the fins is mounted at a different place, but the same fins and the same PCB 2 can be used.

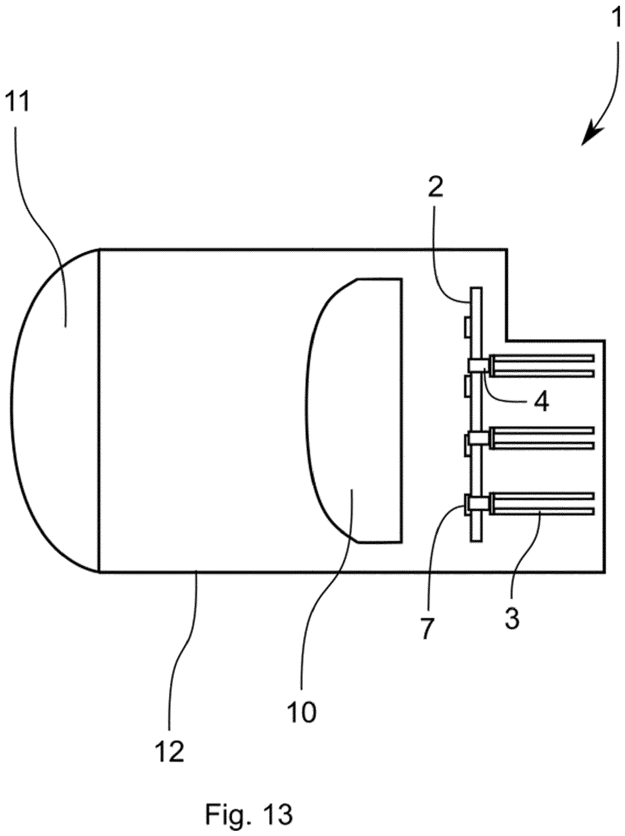

A change in a shape of lamp 1 casing 12 can be another reason for changing the arrangement of the fins in other embodiments. If there is not enough space for the fins at some part of the PCB 2, this part can be left without any fins. This situation is depicted in fig. 13.

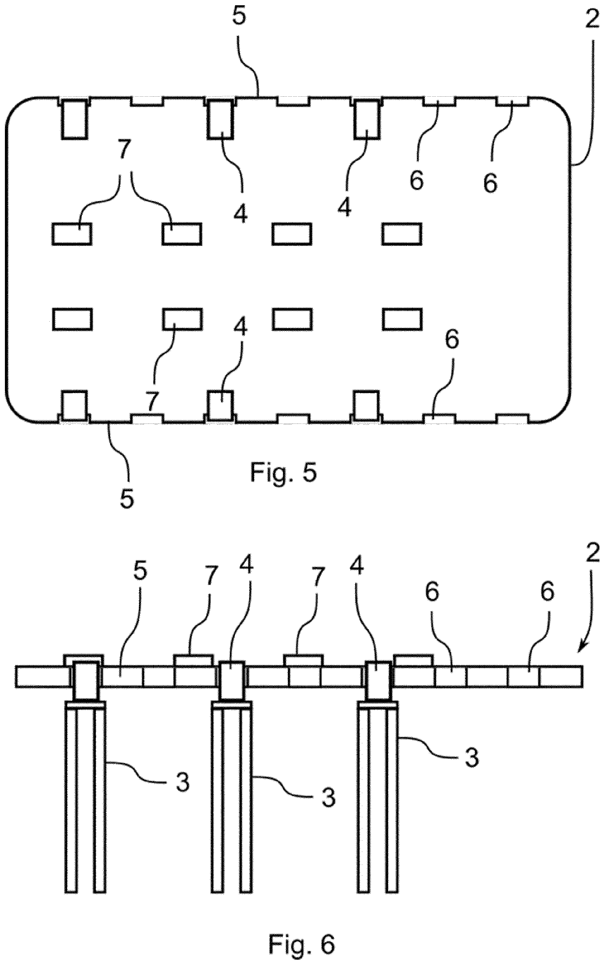

A third exemplary embodiment is shown in figs. 5, 6, 11 and 12. In this embodiment, the PCB 2 is again a PCB 2 with aluminum core, similarly to the first embodiment, only with a different arrangement of LEDs 7. Thickness of this PCB 2 is 2.5 mm.

The two longer edges 5 of the PCB 2 are provided with a number of notches 6, as can be seen in fig. 5. These notches 6 define discrete and equidistant potential positions for the cooling fins 3. Each notch 6 has a notch 6 exactly opposite to it on the other edge 5 and both attaching arms 4 of a cooling fin 3 can thus fit into these notches 6. The fins can thus not be shifted along the PCB 2 in this embodiment.

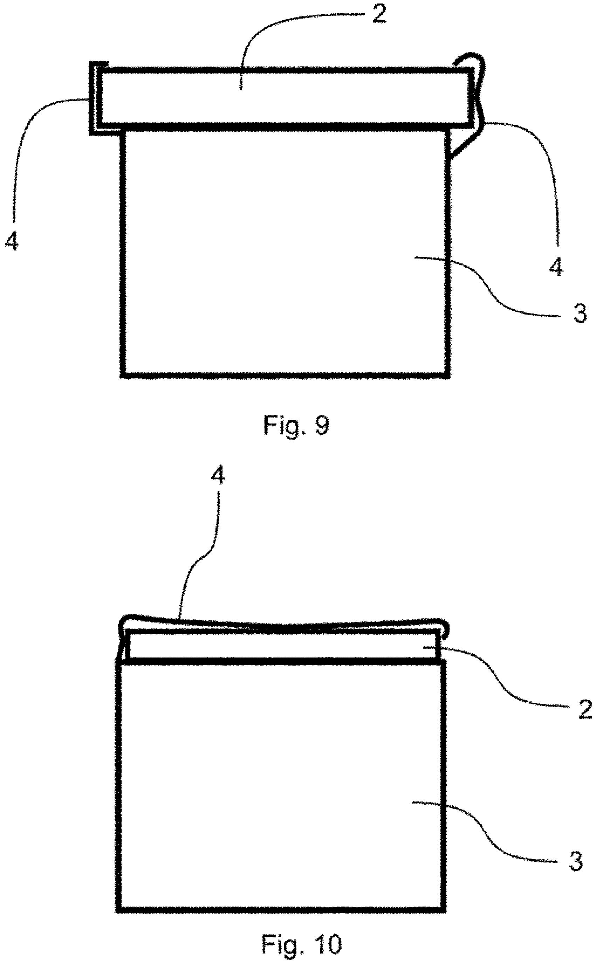

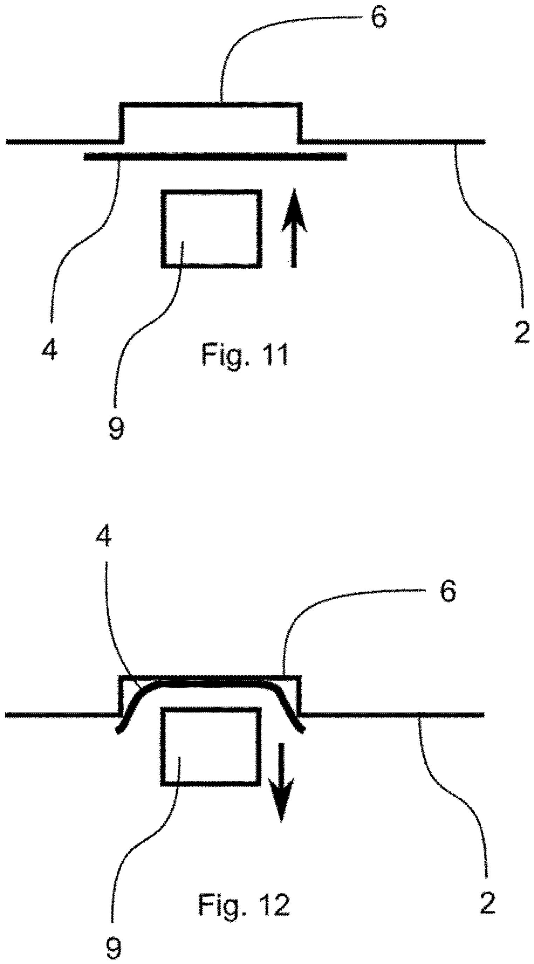

In this embodiment, the fins are made from one piece of material with the attaching arms 4 - aluminum. As a result, the arms are pliable. To prevent even slight movement of the fins, e.g., vibrations due to vehicle movement, each attaching arm 4 is pressed into the respective notch 6 by a pressing tool 9 (see figs. 11 and 12). Before the pressing, each attaching arm 4 in the third embodiment can be shaped similarly to the left attaching arm 4 shown in fig. 9, i.e., it can be angled.

The two shorter edges 5 of the PCB 2 from this embodiment are flat and they can thus be alternatively used for attaching fins in the way according to the first embodiment.

Alternatively, the PCB 2 with notches 6, as in the third embodiment, can be used together with the elastic arms which can be tensioned and are braced against the PCB 2, instead of the pliable arms deformed by the pressing tool 9. With the elastic arms, the notches 6 still limit lateral movement of the cooling fins 3.

A fourth exemplary embodiment is shown in figs. 7, 8 and 9. In this embodiment, the PCB 2 has four edges 5 which are all flat. The attaching arms 4 can thus be placed anywhere along the edges 5 and can be continuously shifted along the edges 5. In this embodiment, the arms are not aligned with the LEDs 7 or spaces between the LEDs 7, as can be seen in fig. 7. The LEDs 7 are not symmetrically distributed, the right side of the PCB 2 is without LEDs 7, and there is thus also a larger area without cooling fins 3 on the right side of the PCB 2. There can be a power source connector provided on the right side, or some other component that does not produce as much heat as the LEDs 7.

The shape of the attaching arms 4 is depicted in fig. 9. One of the arms is angled and can remain static/nondeformed during placing of the PCB 2, while the other arm (on the right in fig. 9) is curved and elastic. During mounting, the PCB 2 is inserted into the angled arm, while the curved arm is bent, and then the curved arm is released. The curved arm thus presses against the PCB 2 thanks to its tensioning and keeps the fin steady.

Other features of this embodiment are analogous to the first embodiment, e.g., the PCB 2 and the cooling fins 3 are from aluminum, the attaching arms 4 are from spring steel, the PCB 2 has a thickness of at least 1.5 mm.

In a fifth embodiment, the cooling assembly is the same as in the fourth embodiment, except that the PCB 2 is smaller and that each cooling fin 3 is only provided with one attaching arm 4, as can be seen in fig. 10. This arm surrounds the PCB 2 from three sides and thus firmly holds the cooling fin 3 on the PCB 2.

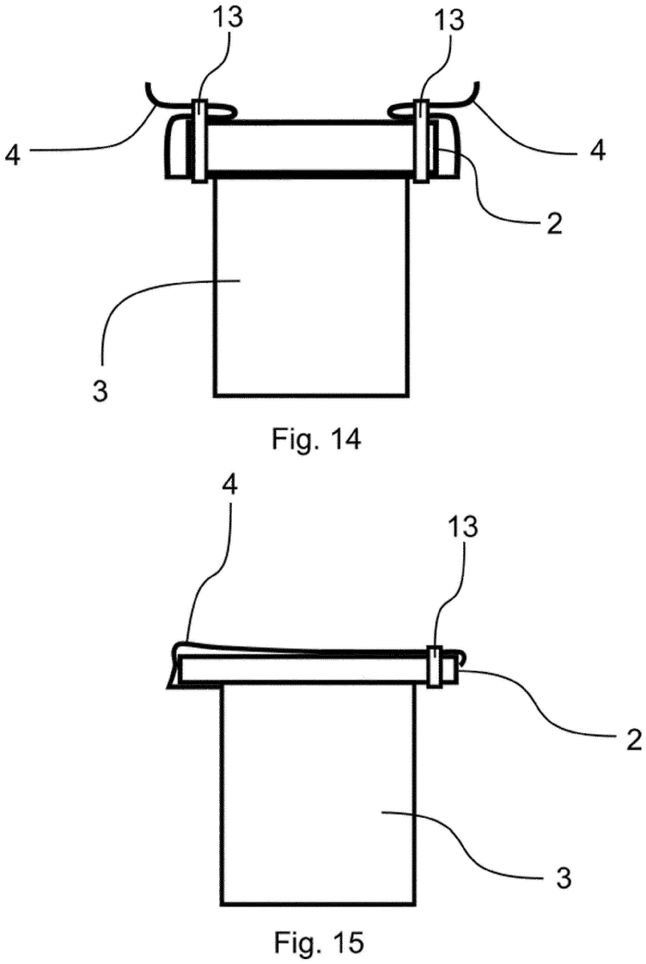

Fig. 14 shows another alternative embodiment. This embodiment is the same as the first embodiment (see fig. 3 for comparison) except that the cooling fins 3 are narrower and there is a binding strip 13 at each edge 5 of the PCB 2. The binding strip 13 surrounds the PCB 2 and forms a closed loop which presses each attaching arm 4 at the corresponding edge 5 of the PCB 2 towards the PCB 2 from above and from below. The length of the loop is thus slightly more than twice the length plus twice the thickness of the PCB 2. The binding strips 13 thus create additional force for keeping the cooling fins 3 steady - the elasticity of the arms is supported by the tightened binding strip 13.

Fig. 15 show an analogous alternative embodiment to the fifth embodiment. The single arm of each cooling fin 3 is supported by a binding strip 13 which fastens the free end of the attaching arm 4 to the PCB 2.

A sixth exemplary embodiment of the invention is a lamp 1 for a vehicle, specifically an automobile headlight module. This module provides one of the standard headlight illumination functions, e.g., a low beam function. A headlight can comprise multiple such modules for different functions. The module according to this embodiment comprises a lamp 1 casing 12, which is a plastic component which encapsulates the rest of the module and holds the module together. The casing 12 carries all the optical and electronical parts of the module and provides attachment to a headlight frame when it's incorporated in a headlight.

This module comprises a primary optics 10, which processes light from a light source, a secondary optics 11, which directs the processed light towards the road ahead, and it also comprises the cooling assembly from the fourth embodiment. The LEDs 7 on the assembly serve as light source for the module, i.e., the LEDs 7 are directed to the primary optics 10. Fig. 13 is a simplified drawing of the module. As mentioned above, the lamp 1 casing 12 has a cut-out portion in its top right corner in fig. 13 so that it can fit into a specific headlight, where the space corresponding to the cut-out portion is occupied by a different component.

The cooling assembly thus has its cooling fins 3 arranged such that it can fit into this specifically shaped casing 12, while providing sufficient heat dissipation. The topmost LED 7 is thus relatively far away from a cooling fin 3, but due to the metal core of the PCB 2 and its thickness, heat can still be effectively conducted away from this LED 7.

In other alternative embodiments, the cooling fins 3 can each have only one branch, e.g., they can be made from single non-bent metal sheet attached to its attaching arm 4. An L-shaped sheet with one bend can be used, where the shorter arm of the "L" forms a base of the fin. In other embodiment, there can be more than two branches on each fin.

In some embodiments, the assembly can comprise different cooling fins 3. For example, the embodiment from fig. 5 can be modified such that the assembly contains two cooling fins 3 with elastic attaching arms 4 from spring steel, and two cooling fins 3 with pliable attaching arms 4 from aluminum pressed into the notches 6. The aluminum arms pressed onto the PCB 2 will have better heat transfer, so they can be provided closer to LEDs 7 producing more heat. The spring arms on the other hand are cheaper to make and mount and can easily be dismounted.

In some embodiments, the notches 6 can be provided on top of the PCB 2, instead of at its sides. The notches 6 are then made as local decreases in the PCB's 2 thickness, instead of its width as in fig. 5. The notches 6 can also be made as local beveling, chamfering, or rounding of the PCB's 2 corners in cross-sections along certain separated intervals along the PCB's 2 length or width.

There can also be embodiments where some fins have their arms in the notches 6 and some fins have their arms outside of the notches 6. In some embodiments, the attaching arms 4 can be secured to the PCB 2 by soldering, welding, gluing etc. In some embodiments, a different material then aluminum, e.g., copper, can be used for the PCB 2 core and/or the cooling fins 3. In some embodiments, multiple cooling fins 3 can share an attaching arm 4. For example, this common arm can be made similarly to the binding strip 13 from fig. 15, such that it extends along the edge 5 of the PCB 2. Each fin can then be provided with a hook or loop for attaching to this arm. The fins can than still be shifted along the PCB 2 so the modularity of the assembly with easily rearrangeable cooling fins 3 is maintained.

### Reference list

- 1.: Lamp
- 2.: Printed circuit board
- 3.: Cooling fin
- 4.: Attaching arm
- 5.: Edge
- 6.: Notch
- 7.: LED
- 8.: Mounting surface for LED
- 9.: Pressing tool
- 10.: Primary optics
- 11.: Secondary optics
- 12.: Casing
- 13.: Binding strip

## Claims

1. Cooling assembly for a light source for a vehicle lamp (1), wherein the assembly comprises a printed circuit board (2) and at least one cooling fin (3), wherein the printed circuit board (2) comprises a metal core, **characterized in that** the assembly comprises at least one attaching arm (4) for at least partially surrounding the printed circuit board (2) and for attaching each cooling fin (3) to the printed circuit board (2).

2. The cooling assembly according to claim 1 **wherein** at least one cooling fin (3) is detachably connected to the printed circuit board (2) by the at least one attaching arm (4).

3. The cooling assembly according to any preceding claim **wherein** for at least one cooling fin (3), at least one corresponding attaching arm (4) forms a snap-on connection for mechanical attachment of the cooling fin (3) to the printed circuit board (2).

4. The cooling assembly according to any preceding claim **wherein** for at least one cooling fin (3), at least one corresponding attaching arm (4) is made from a different, more elastic material than the cooling fin (3).

5. The cooling assembly according to any one of claims 1 to 3 **wherein** for at least one cooling fin (3), at least one corresponding attaching arm (4) is made in one piece with the cooling fin (3) and from the same material.

6. The cooling assembly according to any preceding claim **wherein** for at least one cooling fin (3), there are at least two corresponding attaching arms (4) in total, wherein the printed circuit board (2) is held between the at least two attaching arms (4).

7. The cooling assembly according to any preceding claim **wherein** for at least one cooling fin (3), at least one corresponding attaching arm (4) is elastically deformable during mounting of the cooling fin (3) onto the printed circuit board (2) and presses on the printed circuit board (2) when the cooling fin (3) is mounted to the printed circuit board (2).

8. The cooling assembly according to any one of claims 1 to 6 **wherein** for at least one cooling fin (3), at least one corresponding attaching arm (4) is plastically deformable during mounting of the cooling fin (3) onto the printed circuit board (2).

9. The cooling assembly according to any preceding claim **wherein** the printed circuit board (2) has at least two mutually opposite edges (5) which are both flat, wherein the at least one cooling fin (3) is attachable by the at least one attaching arm (4) to the printed circuit board (2) at any place along the two edges (5).

10. The cooling assembly according to any preceding claim **wherein** the printed circuit board (2) has at least two mutually opposite edges (5), wherein at least one of the two edges (5) comprises multiple notches (6) for receiving a part of an attaching arm (4), wherein the notches (6) are spaced apart from each other.

11. The cooling assembly according to any preceding claim **wherein** the core of the printed circuit board (2) and at least one cooling fin (3) are made from the same metal.

12. The cooling assembly according to any preceding claim **wherein** the printed circuit board (2) comprises multiple LEDs (7), and the assembly comprises at least two cooling fins (3) in total, wherein the cooling fins (3) are mounted to the printed circuit board (2) and their positions are based on positions of the LEDs (7) on the printed circuit board (2).

13. The cooling assembly according to any preceding claim **wherein** the assembly comprises at least three cooling fins (3) in total, wherein the cooling fins (3) are nonuniformly arranged on the printed circuit board (2).

14. Vehicle lamp (1) comprising a light source **characterized in that** in further comprises the cooling assembly according to any preceding claim, wherein the light source is attached to the printed circuit board (2) of the cooling assembly.
